# EUROPEAN PATENT APPLICATION

(11) **EP 1 827 072 A1**
(43) Date of publication of application: **29.08.2007**
(21) Application number: 06077172.2
(22) Date of filing: 05.12.2006
(51) Int. Cl.: H05K 13/02

(54) **Method for guiding a tape as well as flexible strip background**

(30) Priority: 24.02.2006 US 361010
(71) Applicant: Assembléon N.V., 5503 LA Veldhoven (NL)
(72) Inventor: Swab, Michael, Acworth GA 30101 (US)
(74) Representative: Veldman-Dijkers, Cornelia G. C.

(57) **Abstract**

A method is provided for guiding a tape provided with a carrier tape and a cover tape through a component feeder. An end of the cover tape is peeled-off the carrier tape. Subsequently, a flexible strip is attached to the peeled-off end of the cover tape by means of a clip. The flexible strip, including the clip, is guided through a cover tape path of the component feeder.

## Description

### Background

The invention relates to a method for guiding a tape provided with at least a carrier tape and a cover tape through a component feeder. The invention also relates to a flexible strip suitable for being attached to a cover tape.

A conventional method is disclosed in European patent application EP-A1-0,963,149, in which a relatively long tape is wound on a reel and is guided from the reel to a component pick-up position. Near the component pick-up position, the cover tape is removed from the carrier tape to open compartments in the carrier tape, thereby providing access to components located in said compartments. By means of a pick-up device, a component is removed from a compartment and is placed on a printed circuit board. The peeled-off cover tape is wound on a cover tape take-up reel or expelled into waste tape bin.

If only small amounts of components are needed, manufacturers sometimes use a relatively short piece of tape comprising the exact amount of components needed. These short pieces of tape vary in length but usually contain less than one hundred components and have an average of twenty to fifty components per tape. The problem associated with using such a short piece of tape is that the cover tape cannot be guided through the whole cover tape path of the component feeder to the cover tape reel. As a result, the component feeder cannot be used.

One current solution entails removing the entire cover tape from the tape such that the components are exposed and the tape is used as a kind of tray from which the components are picked-up. This has the disadvantage that the component feeder cannot be used and that a place needs to be available on which the tape can be located to be used as a kind of tray. Furthermore, it requires a relatively long set-up time and the size of the circuit board that can be run might be reduced.

It is also known to use waste cover tape and to knot the waste tape to the cover tape of the short piece of tape. Unfortunately, to be able to knot the waste tape to the cover tape, a relatively long piece of the cover tape needs to be peeled-off. Furthermore, knotting the tapes together is relatively cumbersome an time consuming.

What is needed, therefore, is an apparatus and a methodology that address at least one if not more of the deficiencies that afflict conventional practice, as previously described.

### Summary

An embodiment of the present invention addresses a method by which an end of a cover tape is peeled-off a carrier tape. Subsequently, a flexible strip is attached to the peeled-off end of the cover tape by means of a clip. The flexible strip is guided through a cover tape path of the component feeder. The clip may be easily attached to the peeled-off end of the cover tape so that the set-up time for the relatively short piece of tape in the component feeder is relatively short. The clip can be attached to a relatively small piece (e.g., about 5 mm to 10 mm) of the cover tape, so that only a small amount of the cover tape needs to be peeled-off before the component feeder can be operated. The clip may be relatively small so that it can easily pass through guide rollers in the cover tape path of the component feeder.

According to another embodiment of the present invention, the flexible strip may be detachably attached to the cover tape. As the flexible strip is detachably attached to the cover tape, it may be easily removed from the cover tape after the whole cover tape is removed from the carrier tape, so that the flexible strip can be reused.

According to another embodiment of the present invention, the clip may be a spring loaded clip. Such a spring loaded clip can easily be attached to the peeled-off end of the cover tape, whereby, due to a spring force of the spring, a strong hold of the end of the cover tape may be obtained.

According to another embodiment of the present invention, the clip may be provided with teeth for grasping the end of the cover tape. By means of such teeth, a good grip on the cover tape may be obtained.

According to another embodiment of the present invention, the clip may be provided with a polymer coating such as vinyl for grasping the end of the cover tape. Such coating may provide a strong hold on the cover tape.

According to another embodiment of the present invention, the strip may be made of vinyl coated Nylon or a coated Kevlar type material. Such a material may be relatively flexible in bending and relatively rigid in tension, so that the strip may suitable for use in a component feeder.

These and other features, aspects and advantages of the present invention will become more apparent from the following description, appended claims, and accompanying exemplary embodiments shown in the drawings.

Figure 1 shows a conventional component feeder;

Figure 2 shows a first embodiment of a flexible strip according to the present invention;

Figure 3 shows a second embodiment of a flexible strip according to the present invention; and

Figure 4 shows a side view of a conventional tape.

### Detailed description

Presently preferred embodiments of the invention are illustrated in the drawings. An effort has been made to use the same, or like, reference numbers throughout the drawings to refer to the same or like parts.

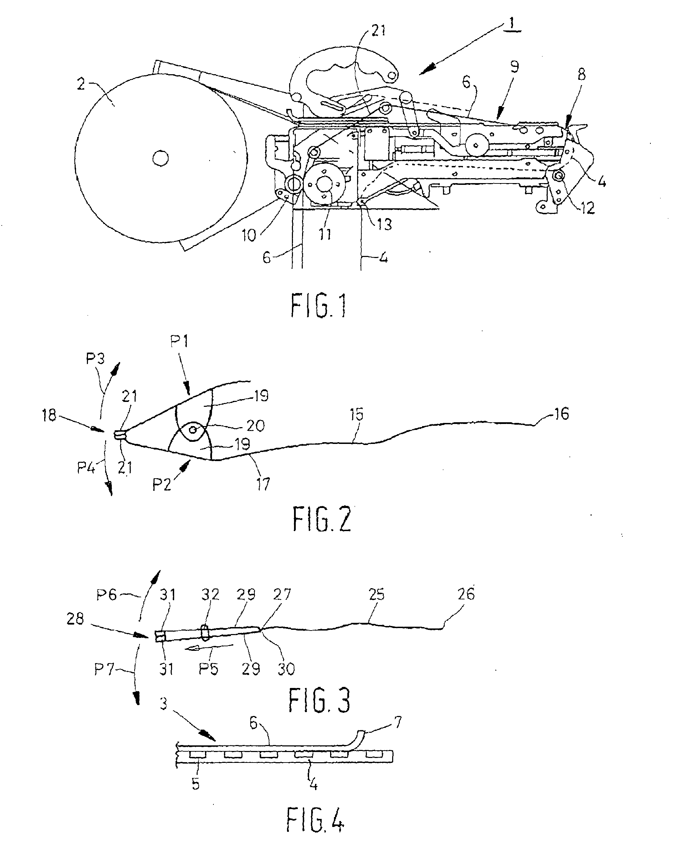

Figure 1 shows a component feeder 1 as is known in the art comprising a tape reel 2 on which a tape 3 (shown in Figure 4) can be wound. Such a tape 3 comprises a carrier tape 4 provided with compartments 5 in which components are located. The compartments 5 are closed by means of a cover tape 6. As shown in Figure 4, an end 7 of the cover tape 6 has been peeled-off the carrier tape 4.

The component feeder 1 comprises a guiding means for guiding the tape 3 from the reel 2 to a component pick-up position 8. Between the reel 2 and the component pick-up position 8, a peel-off knife 9 is located around which the peeled-off cover tape 6 is guided away from the carrier tape 4. In this way, the components located in a compartment 5 of the carrier tape 4 will be exposed at the component pick-up position 8 and can be removed therefrom by means of a component pick- and place-unit (not shown).

The cover tape 6 is guided through guide rollers 10, 11 to a waste bin or to take-up reel (not shown). The carrier tape 4 is guided along a roller 12 and a guiding means 13 to another waste bin or another take-up reel (not shown). As such component feeders are well known in the art, amongst others form the above mentioned European patent application, the component feeder 1 will not be further explained.

Figure 2 shows a first embodiment of a flexible strip 15 according to the invention, made of, for example, vinyl coated nylon or a coated Kevlar type material. The flexible strip 15 is relatively flexible in bending but relatively rigid in tension. The flexible strip is free at a first end 16 and provided with a clip 17 at the second end 18. The clip 17 comprises two jaws 19 that are pivotally connected to each other at a pivot axis 20. At an end remote from the flexible strip 15, the jaws 19 are provided with grasping surfaces 21. The grasping surfaces 21 can be provided with teeth or with a strong bur soft polymer coating such as vinyl, to produce a strong hold of the cover tape 6. Near the pivot axis 20, a spring is provided by means of which the grasping surfaces 21 are pushed against each other.

If a relatively short piece of tape 3 is to be used in the component feeder1, the tape 3 is guided in the component feeder 1 until an end 7 of the cover tape 6 can be peeled back and fed along the peel-off knife 9. The length of the peeled-off part of the end 7 will be between, e.g., about 5 mm and about 10 mm. The operator will then (manually) push the jaws 19 in the directions indicated by arrows P1, P2 due to which the grasping surfaces 21 will be pivoted against the spring force of the spring about pivot axis 20 in the directions indicated by the arrows P3, P4. The grasping surfaces 21 will be positioned around the peeled-off end 7 of the cover tape 6 due to which the cover tape 6 is extended by the flexible strip 15. The flexible strip 15 is guided in the component feeder 1 along the cover tape path 22 in the same way as a relatively long cover tape 6 as previously explained with reference to Figure 1.

The clip 17 is relatively small and can easily be guided through the guide rollers 10, 11. In this manner the relatively short piece of tape 3 can be used in the conventional component feeder 1. The relatively short piece of tap 3 is used in conjunction with a flexible strip 15 the length of which might be, e.g., about 30 cm whereas the width of the flexible strip 15 may be similar to the width of the cover tape 6, i.e., less than or equal to about 8 mm. After the entire cover tape 6 has been removed from the carrier tape 4, the flexible strip 15 will be detached from the cover tape 6. The cover tape 6 will be disposed of whereas the flexible strip 15 can be reused.

Figure 3 shows a second embodiment of a flexible strip 25 having a first free end 26 that can easily be guided through the cover tape 22 of the component feeder 1. The flexible strip 25 is provided near a second end 27 with a clip 28. The clip 28 comprises two jaws 29 that are pivotally connected to each other at a pivot axis 30. At the side remote from the pivot axis 30, the jaws 29 are provided with grasping surfaces 31. The clip 28 is provided with a ring shaped element 32 located around the jaws 29. By moving the element 32 in the direction as indicated by arrow P5, a force, by means of which the grasping surfaces 31 are pressed against each other, will be increased. When the element 32 is moved in the direction of pivot axis 30, the jaws 29 can be moved apart in the directions as indicated by the arrows P6, P7, thereby enabling the clip 28 to be attached to the peeled-off end 7 of the cover tape 6. The dimensions of the clip 28 are even smaller than the dimensions of the clip 17 so that the flexible strip 25 and the clip 28 attached thereto can easily be guided along the cover tape path 22 and through the guide rollers 10, 11.

Depending on the exact dimensions of the clip 28, the clip 28 can also be wound on the reel for the cover tape 6. However, by the time the clip 28 reaches the reel, the amount of components on the relatively short piece of tape 3 will have been exhausted so that no further transportation of the flexible strip 25 will be needed. The clip 28 will be removed and can be reused.

It is of course also possible to discharge the strip 15, 25 together with the clip 17, 28 attached thereto. In addition, if an operator wishes to reuse the component feeder 1 with a relatively long tape 3 wound on a reel 2, the operator may simply not use a flexible strip 15, 25 and instead may use the component feeder 1 the conventional matter.

The small amount of time necessary to use the component feeder 1 with relatively small pieces of tape 3 is due to the ease of attachment of the flexible strip 15, 25 to the peeled-off end 7 of the cover tape 6. Specifically, the time will only be about a few seconds.

Although the aforementioned describes embodiments of the invention, the invention is not so restricted. It will be apparent to those skilled in the art that various modifications and variations can be made to the disclosed embodiments of the present invention without departing from the scope or spirit of the invention. Accordingly, these other apparatuses and methods are fully within the scope of the invention. Therefore, it should be understood that the apparatuses and methods described herein are illustrative only and are not limiting upon the scope of the invention, which is indicated by the following claims.

## Claims

1. A method for guiding a tape provided with at least a carrier tape and a cover tape through a component feeder, the method comprising the steps of:
peeling an end of the cover tape off the carrier tape;
attaching a flexible strip to the peeled-off end of the cover tape by means of a clip;
and
guiding the flexible strip through a cover tape path of the component feeder.

2. The method according to claim 1, wherein the flexible strip is detachably attached to the cover tape.

3. The method according to anyone of the proceeding claims, wherein the clip is a spring loaded clip.

4. The method according to anyone of the proceeding claims, wherein the clip is a spring loaded clip.

5. The method according to anyone of the proceeding claims, wherein the clip is provided with teeth for grasping the end of the cover tape.

6. The method according to anyone of the proceeding claims, wherein the clip is provided with a polymer coating such as vinyl for grasping the end of the cover tape.

7. The method according to anyone of the proceeding claims, wherein the strip is made of vinyl coated Nylon or a coated Kevlar type material.

8. The method according to anyone of the proceeding claims, wherein the flexible strip is relatively rigid in tension.

9. An apparatus comprising:
a flexible strip; and
a clip;
wherein the clip is provided near one end of the strip and is configured to connect the flexible strip to a cover tape.

10. The apparatus according to anyone of the proceeding claims, wherein the clip is a spring loaded clip.

11. The apparatus according to anyone of the proceeding claims, wherein on a side remote from the clip, the flexible strip is provided with a free end.

12. The apparatus according to anyone of the proceeding claims, wherein on a side remote from the clip, the flexible strip is provided with a free end.

13. The apparatus according to anyone of the proceeding claims, wherein the flexible strip has a length of about 30 cm.

14. The apparatus according to anyone of the proceeding claims, wherein the flexible strip has a width of about 8 mm.

15. The apparatus according to anyone of the proceeding claims, wherein the flexible strip is provided with teeth for grasping the end of the cover tape.

16. The apparatus according to anyone of the proceeding claims, wherein the flexible strip is provided with a polymer coating such as vinyl for grasping the end of the cover tape.

17. The apparatus according to anyone of the proceeding claims, wherein the flexible strip is made of vinyl coated Nylon or a coated Kevlar type material.

18. The apparatus according to anyone of the proceeding claims, wherein the flexible strip is relatively rigid in tension.
